# EUROPÄISCHE PATENTSCHRIFT

(11) **EP 1 783 910 B1**
(45) Veröffentlichungstag und Bekanntmachung des Hinweises auf die Patenterteilung: **31.10.2012**
(21) Anmeldenummer: 05024239.5
(22) Anmeldetag: 07.11.2005
(51) Int. Cl.: H03K 17/691, H03K 17/567, H03K 17/687, H02M 1/08, H03K 17/06

(54) **Schaltungsanordnung und ein Verfahren zur galvanisch getrennten Ansteuerung eines Halbleiterschalters**
Circuit and a method for the galvanically separated control of a semiconductor switch
Circuit et un procédé pour commander d'une manière galvaniquement séparée un commutateur semi-conducteur

(43) Veröffentlichungstag der Anmeldung: 09.05.2007
(73) Patentinhaber: Bosch Rexroth AG, 70184 Stuttgart (DE)
(72) Erfinder: Dittrich, Thomas, 97854 Steinfeld (DE)

(56) Entgegenhaltungen:
- WO-A-90/13178
- DE-A1- 19 814 745
- US-A- 4 461 966
- US-A- 4 705 962
- US-A- 4 970 420
- PATENT ABSTRACTS OF JAPAN Bd. 010, Nr. 104 (E-397), 19. April 1986 (1986-04-19) & JP 60 244120 A (TDK KK), 4. Dezember 1985 (1985-12-04)

## Beschreibung

Die vorliegende Erfindung betrifft eine Schaltungsanordnung und ein Verfahren zur galvanisch getrennten Ansteuerung eines Halbleiterschalters.

### Stand der Technik

Zur Anwendung kommen potentialfreie Gateansteuerungen in der Leistungselektronik immer dann, wenn sich die Ansteuerelektronik und der Schalter, zumindest zeitweise, auf unterschiedlichem Potential befinden. Dies ist z. B. bei Tiefsetzstellern, Wechielrichterbrücken, Phasenanschnittsteuerungen im Wechselstromnetz der Fall.

Bei bekannten Schaltungsrealisierungen wird beispielsweise das Gate des Halbleiterschalters über einen Treiber mit optoelektronischer Trennung angesteuert. Die Bereitstellung der versorgungsspannung des Treibers und damit auch der Ansteuerleistung des Halbleiterschalters wird über ein galvanisch getrenntes Netzteil mit Hochfrequenztransformator realisiert.. Bei diesem Schaltungskonzept sind daher zwei potentialgetrennte Strompfade zur Ansteuerung eines Schalters mit entsprechendem Schaltungsaufwand notwendig.

Es gibt auch Lösungen, bei denen Schaltleistung und Schaltsignal miteinander über einen Transformator übertragen werden. Das Steuersignal zum Einschalten des Halbleiterschalters wird als hochfrequentes Signal am Primäreingang des Transformators bereitgestellt. Zum Ausschalten des Schalters wird das primärseitige Signal abgestellt. Diese Schaltungsanordnung kommt zwar ohne zusätzliche Hilfsversorgungsspannung für die Schaltglieder der Leistungsseite aus, die Genauigkeit der Schaltsignale ist aber für eine Vielzahl von Anwendungen nicht ausreichend. Zum Schalten des Halbleiterschalters in den nicht-leitenden Zustand wird die Spannung an der primärseitigen Wicklung des Transformators entfernt. Dadurch kann sich das Gate des Halbleiterschalters über einen angeschlossenen Transistor entladen, wobei es schließlich ein Restpotential in Höhe der Transistor-Basis-Emitter-Spannung, bei einem Darlington-Transistor bspw. 1,4 V, zusammen mit Spannungen, die an im Strompfad liegenden Widerständen abfallen, aufweist. Im Stand der Technik werden dabei Rest-Gatespannungen von etwa 2,5 V erreicht. Da durch die Umladung der Miller-Kapazität des Halbleiterschalters zusätzliche Spannungsspitzen auftreten können, stellt sich das Problem, dass der Halbleiterschalter, bei Erreichen seiner minimalen Einschaltspannung, unbeabsichtigt in den leitenden Zustand zurückgesetzt wird (Doppel- oder Mehr fachschalten). Eine derartige Schaltungsanordnung ist daher bspw. für einen Hochfrequenzbetrieb in Wechselrichtern nicht geeignet.

Für derartige Fälle werden im Stand der Technik Ansteuerungen über einen Optokoppler verwendet, die, wie oben erwähnt, einen erhöhten Bauteilaufwand erforden und daher relativ teuer in der Herstellung sind. Zusätzlich treten in dieser Lösungsform höhere Schaltungsverluste auf, da zusätzlich zur Ansteuerenergie des Schalters auch die Versorgungsenergie des Treiberbausteins bereitgestellt werden muss.

In der WO 90/13178 ist eine Schaltungsanordnung zum galvanisch getrennten Schalten eines Leistungstransistors offenbart, wobei ein Steuerkreis über einen Transformator mit einem Treiberkreis verbunden ist. Eine in den Treiberkreis induzierte Spannung schließt einen ersten Steuertransistor, der wiederum den Leistungstransistor öffnet. Zum Abschalten des Leistungstransistors wird das Steuersignal im Steuerkreis abgeschaltet, woraufhin eine negative Spannung in den Treiberkreis induziert wird, die einen zweiten Steuertransistor beaufschlagt, um den Leistungstransistor mittels eines geladenen Kondensators zu öffnen. Die Schaltungsanordnung benötigt zwei Steuertransistoren sowie eine relativ große Kapazität des Kondensators. Weiterhin ist die Schaltungsanordnung nicht in der Lage, ein dauerhaftes Ansteuern des Leistungstransistors zu gewährleisten.

Änliche Schaltungsanordnung en werden in der JP 60-244120 sowie der US 4,461,966 offenbart.

Es stellt sich daher das Problem, eine Schaltungsanordnung und eine Vorrichtung zur galvanisch getrennten Ansteuerung eines Halbleiterschalters anzugeben, die bei vermindertem Bauteil- und damit Kostenaufwand insbesondere für Hochfrequenzwechselrichterbetrieb geeignet ist.

Erfindungsgemäß werden eine Schaltungsanordnung sowie ein Verfahren zur galvanisch getrennten Ansteuerung eines Halbleiterschalters gemäß den unabhängigen Patentansprüchen vorgestellt. Vorteilhafte Ausgestaltungen sind Gegenstand der Unteransprüche.

### Vorteile der Erfindung

Die nachfolgende Beschreibung gilt gleichermaßen für die erfindungsgemäße Schaltungsanordnung sowie für das erfindungsgemäße Verfahren, soweit es nicht ausdrücklich anders beschrieben ist.

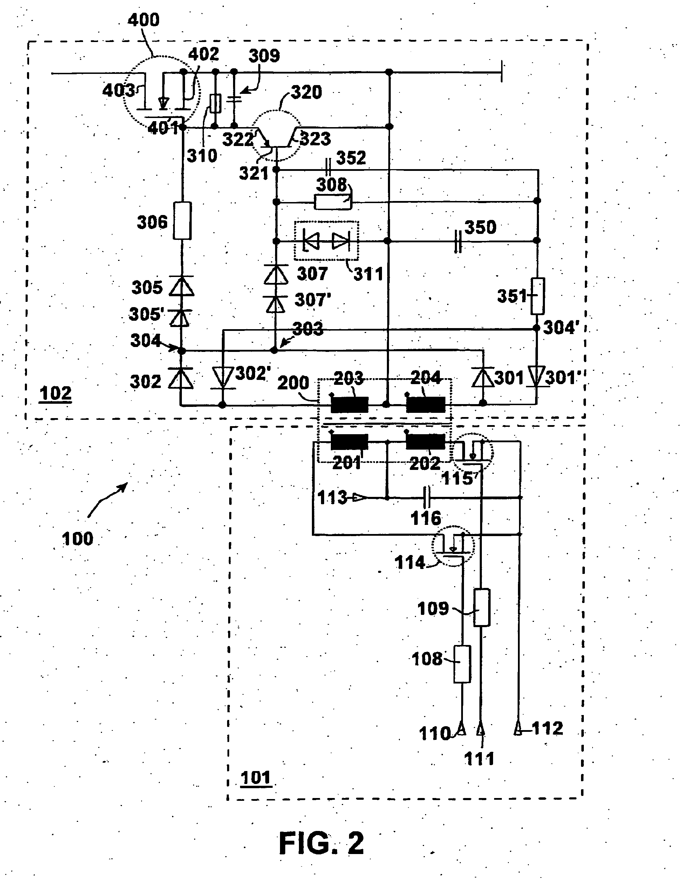

Durch die vorliegende Erfindung kann der Bauteilaufwand reduziert werden. Dadurch lassen sich die Schaltungsanordnungen kostengünstiger herstellen. Indem die Ansteuerung des Schalters nur über einen Strompfad realisiert wird, d.h. das Ansteuersignal gleichzeitig die Ansteuerleistung bereitstellt, kann der Schaltungsaufwand (Kosten, Anzahl der Bauteile, Platzbedarf) minimiert werden. Als weiterer Vorteil ergibt sich ein sehr geringer Leistungsbedarf, da nur die Ansteuerleistung des Schalters aus der Steuerspannungsversorgung bereit gestellt werden muss, im bevorzugten Ausführungsbeispiel gemäß Figur 2 bspw. nur 0,8 W pro Treiberstufe bei 16 Khz Pulsbreitenmodulation. Prinzipiell wird nur das Ein- oder Ausschaltsignal (je nach verwendetem Halbleiterschalter und/oder Steuertransistor, z.B. unipolar, bipolar, n-kanal, p-kanal, npn, pnp, usw.; Es versteht sich für den Fachmann, welche Kombination aus Halbleiterschalter und Steuertransistor für den Einsatzzweck geeignet ist) potentialfrei übertragen. Der andere Schaltvorgang wird passiv auf Schalterpotential realisiert.

Bei einer bevorzugten Ausgestaltung der Erfindung ist die Basiselektrode des Steuertransistors mit einem Pol der Spannungserzeugungsmittel und über wenigstens zwei, vorzugsweise drei Dioden mit der Source-Elektrode des Halbleiterschalters verbunden. Diese Verbindung kann über den Hochfrequenz Transformator erfolgen. Dadurch kann eine vorbestimmmte Spannungsdifferenz, bei drei Si-Dioden beispielsweise 2,1 V, zwischen der Basiselektrode des Steuertransistors und der Source-Elektrode des Halbleiterschalters bzw. Masse realisiert werden. Somit kann die Gate-Elektrode des Halbleiterschalters vorteilhaft bis auf Null-Potential gebracht werden.

Erfindungsgemäß sind die Spannungserzeugungsmittel als wenigstens ein kapazitives Bauteil, insbesondere als Kondensator mit vorzugsweise 10 nF, ausgebildet. Weiterhin kann vorteilhaft ein resistives Bauteil, insbesondere ein Widerstand, zur Ladestrombegrenzung vorgesehen sein. Damit ist die beabsichtigte dritte Spannung einfach zu erhalten. Das kapazitive Bauteil wird bei einem Schaltungsvorgang geladen, woraufhin es die dritte Spannung für den anderen Schaltungsvorgang bereitstellen kann.

Bevorzugterweise weist die Erfindung eine Diodenanordnung, welche wenigstens eine Z-Diode mit Verpolschutz aufweist, zwischen der Basiselektrode und der Kollektorelektrode des Steuertransistors zum Begrenzen der Spannung zwischen der Gate-Elektrode und der Source-Elektrode des Halbleiterschalters auf. Dadurch kann der Halbleiterschalter vor Beschädigungen geschützt werden.

Es ist von Vorteil, wenn bei der Erfindung ein kapazitives Bauteil, insbesondere einen Kondensator, zwischen der Gate-Elektrode und der Source-Elektrode.des Halbleiterschalters zum Abpuffern von über eine Miller-Kapazität des Halbleiterschalters eingekoppelten Störströmen vorgesehen ist. Durch die Miller-Kapazitäten zwischen den Elektroden des Halbleiterschalters werden hohe Stromspitzen eingekoppelt, die den Betrieb der Anordnung, bspw. in einem Wechselrichter während der Einschaltphase, stören können. Diese werden durch die vorgesehene Kapazität abgepuffert und ihre Wirkung somit unterdrückt.

Zweckmäßigerweise ist bei der Erfindung der Halbleiterschalter als unipolarer Transistor, insbesondere als FET, MOSFET oder IGBT, ausgebildet. Diese Transistoren' erlauben mit geringer Schaltleistung das Schalten großer Ströme.

Bei.einer sehr bevorzugten Ausgestaltung der Erfindung sind der Halbleiterschalter als unipolarer n-Kanal Transistor und der Steuertransistor als bipolarer pnp-Transistor ausgebildet, wobei die Gate-Elektrode des Halbleiterschalters mit der Emitterelektrode des Steuertransistors, und die Source-Elektrode des Halbleiterschalters mit der Kollektorelektrode des Steuertransistors verbunden sind, und die Spannungserzeugungsmittel zum Erzeugen einer negativen Spannung zwischen der Basiselektrode und der Kollektorelektrode des Steuertransistors ausgebildet sind. Diese Lösung kann vorteilhaft zum Betreiben in. Wechselrichtern für Drehstrommotoren verwendet werden, wobei ein Signal im Steuerkreis den Halbleiterschalter schließt, also Strom fließen lässt, und nach Abschalten des Steuersignals der Halbleiterschalter mittels der erfindungsgemäßen Hilfsspannung geöffnet wird.

Ebenso bevorzugt sind bei der Erfindung die Basiselektrode des Steuertransistors, insbesondere über einen Widerstand, mit dem negativen Pol der Spannungserzeugungsmittel und über wenigstens zwei, vorzugsweise drei Dioden, insbesondere über den Hochfrequenztransformator, mit der Source-Elektrode des Halbleiterschalters bzw. Masse verbunden. Durch diese Ausgestaltung wird die Basis des Steuertransistors in der Ausschaltphase auf negatives Potential gelegt. Damit läßt sich vorteilhaft mittels der bereitgestellten negativen Hilfsspannung das Gate bis auf Null-Potential führen, da eine negative Spannung, bei drei Si-Dioden z.B. 2,1 V, zwischen der Basiselektrode des Steuertransistors und der Source-Elektrode des Halbleiterschalters bzw. Masse besteht.

Weitere Vorteile und Ausgestaltungen der Erfindung ergeben sich aus der Beschreibung und der beiliegenden Zeichnung.

Es versteht sich, dass die vorstehend genannten und die nachstehend noch zu erläuternden Merkmale nicht nur in der jeweils angegebenen Kombination, sondern auch in an deren Kömbinationen oder in Alleinstellung verwendbar sind, ohne den Rahmen der vorliegenden Ansprüche zu verlassen.

Die Erfindung ist anhand eines Ausführungsbeispiels in der Zeichnung schematisch dargestellt und wird im folgenden unter Bezugnahme auf die Zeichnung ausführlich beschrieben.

### Figurenbeschreibung

- Figur 1: zeigt ein Schaltungsdiagramm einer Schaltungsanordnung zur galvanisch getrennten Ansteuerung eines Halbleiterschalters gemäß dem Stand der Technik; und
- Figur 2: zeigt ein Schaltungsdiagramm einer erfindungsgemäßen Schaltungsanordnung zur galvanisch getrennten Ansteuerung eines Halbleiterschalters.

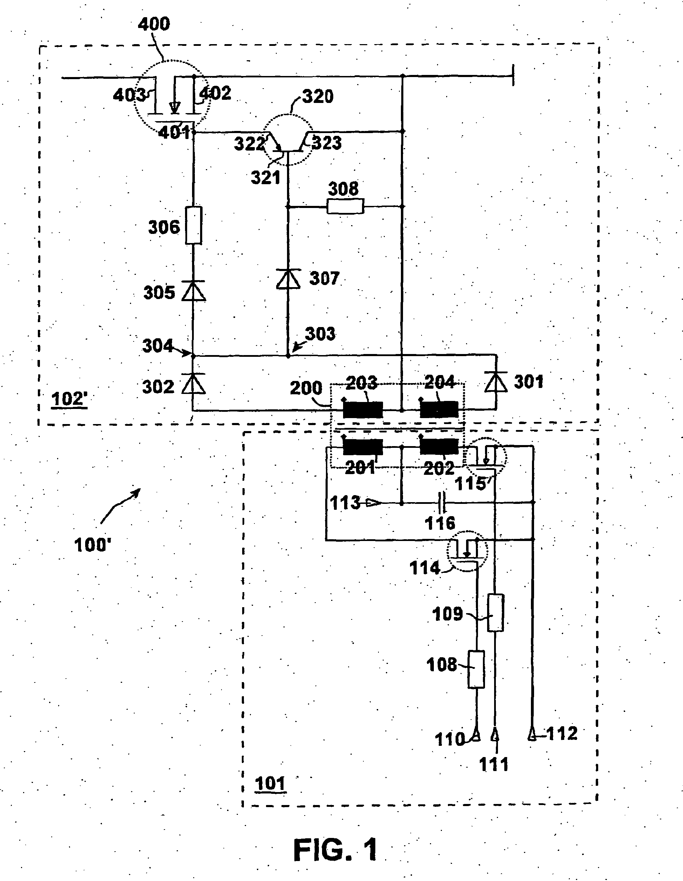

Anhand Figur 1 wird zunächst eine Schaltungsanordnung 100' gemäß dem Stand der Technik beschrieben.

Die Schaltungsanordnung 100' lässt.sich in zwei Bereiche unterteilen, einen Steuerkreis 101 (Schaltungsteil auf Ansteuerpotential) und einen Treiberkreis 102' (Schaltungsteil auf Schalterpotential). Die beiden Kreise sind über einen Transformator 200 mit zwei primären Spulen 201, 202.und zwei sekundären Spulen 203, 204 galvanisch getrennt gekoppelt.

Im Steuerkreis 101 werden die Ansteuersignale über Anschlüsse 110 und 111 bereitgestellt. Ein Anschluss 112 liegt an Masse. Ein Anschluss 113 ist mit einer positiven Versorgungsspannung, in diesem Beispiel 15 V, verbunden. An den Eingängen 110, 111 liegt eine komplementäre Ansteuerung, beispielsweise mit einer Schaltfrequenz von 250 kHz und einer vorbestimmten Einschaltverzögerung von bspw. 30 ns, an. Dieses Signal kann beispielsweise einer Logikschaltung entnommen werden oder von einem herkömmlichen Computer, der eine entsprechende Steuerkarte aufweist, bereitgestellt werden. Das Signal liegt im Niedervoltbereich, bspw. bei etwa 2,5 V. Durch das Ansteuersignal werden Transistoren 114, 115 abwechselnd in einen leitfähigen Zustand versetzt. Damit wird die am Eingang 113 anliegende Versorgungsspannung abwechselnd über die Primärspulen 201 und 202 mit Masse 112 verbunden. Zur Stützung der Versorgungsspannung ist zusätzlich ein Kondensator 116 zwischen Versorgungsspannung und Masse 112 angeschlossen.

Auf der Treiberkreisseite 102' wird eine vorbestimmte Spannung in die Sekundärspulen 203 und 204 induziert. Über Dioden 301, 302 wird eine positive Spannung an Knotenpunkten 303 und 304 bereitgestellt. Zur Glättung dieser Spannung kann ein Kondensator vorgesehen sein. Die Amplitude dieser Spannung wird durch das Übersetzungsverhältnis des Transformators 200 bestimmt. Sie wird so eingerichtet, dass die Gatesteuerspannung eines anzusteuernden Halbleiterschalters 400, der als n-Kanal MOSFET ausgebildet ist, erreicht wird, vorzugsweise 15 V.

Die positive Spannung am Knotenpunkt 304 wird über eine Diode 305 und einen Widerstand 306 an das Gate 401 des MOSFETs 40.0 angelegt. Dadurch wird der MOSFET 400 zwischen seiner Source- und Drain-Elektrode 402 und 403 leitend. Die positive Steuerspannung liegt über dem Knotenpunkt 303 und eine weitere Diode 307 auch an einer Basis 321 eines Steuertransistors, in diesem Beispiel eines pnp-Transistors 320. Zwischen der Gate-Elektrode 401 des MOSFETs 400 und der Basiselektrode 321 des pnp-Transistors 320 liegt in diesem Fall keine Spannung an.

Eine Emitterelektrode 322 des pnp-Transistors 320 ist mit der Gate-Elektrode 401 des MOSFETs 400 verbunden. Eine Kollektorelektrode 323 des pnp-Transistors 320 ist mit der Source-Elektrode 402 des MOSFETs 400 verbunden. Weiterhin sind die Kollektorelektrode 323 des pnp-Transistors 320 und die Source-Elektrode 402 des MOSFETs 400 mit Masse verbunden. Die Basiselektrode 321 des pnp-Transistors 320 ist über einen Widerstand 308 ebenfalls mit Masse verbunden.

Um den MOSFET 400 in den nicht-leitenden Zustand zurück zu versetzen, wird das Ansteuersignal im Steuerkreis 101 abgeklemmt. Dadurch wird in die Sekundärspulen 203, 204 im Treiberkreis 102' keine Spannung mehr induziert. Die an der Basiselektrode 321 des pnp-Transistors 320 anliegende positive Spannung fällt nun über den Widerstand 308 auf Massepotential ab. Die an der Gate-Elektrode 401 des MOSFETs 400 anliegende positive Spannung ist über die Dioden 305, 302 von Masse getrennt. Somit baut sich eine negative Spannung zwischen der Basiselektrode 321 des pnp-Transistors 320 und der Gate-Elektrode 401 des MOSFETs 400 auf. Erreicht diese negative Spannung einen vorbestimmten Wert, den Schwellwert des pnp-Transistors 320, so wird der pnp-Transistor 320 zwischen seiner Emitterelektrode 322 und seiner Kollektorelektrode 323 leitend. Die Gate-Elektrode 401 des MOSFETs 400 ist damit ebenfalls mit Massepotential verbunden, wodurch sie sich entlädt. Unterschreitet nun die an der Gate-Elektrode 401 anliegende positive Spannung den Schwellspannungswert des MOSFETs, wird dieser nicht-leitend.

Dabei kann sich das Gate 401 des MOSFETA 400 über den angeschlossenen pnp-Transistor 320 nur bis zu einem Restpotential in Höhe der Transistor-Basis-Emitter-Spannung, bei einem Darlington-Transistor bspw. 1,4 V, und der Spannung, die am Widerstand 308 abfällt, entladen. Dabei werden Rest-Gatespannungen von etwa 2,5 V erreicht. Da über die Miller-Kapazität des MOSFETs im Ausschaltmoment zusätzliche Spannungsspitzen durch Umladevorgänge entstehen, stellt sich das Problem, dass der Halbleiterschalter unbeabsichtigt in den leitenden Zustand zurückgesetzt wird (Doppel- oder Mehrfachschalten), wenn die Gate-Spannung die minimale Einschaltspannung von beispielsweise etwa 5 V erreicht.

Zur Verbesserung der genannten Probleme wird daher die erfindungsgemäße Lösung vorgeschlagen. Diese wird im folgenden anhand Figur 2 erläutert.

Zunächst sollen die Unterschiede in der Schaltungsanordnung zum Stand der Technik (Figur 1) erläutert werden. Der Steuerkreis 101 der beiden Schaltungsanordnungen 100 und 100' ist jeweils identisch aufgebaut.

Der Treiberkreis (Schaltungsteil auf Schalterpotential) 102 der Schaltungsanordnung 100 unterscheidet sich hingegen vom Treiberkreis 102' der Schaltungsanordnung 100' (Stand der Technik).

Neben den beschriebenen Dioden 301, 302 zum Bereitstellen einer positiven Spannung an den Punkten 303, 304 sind nun auch Dioden 301', 302' vorgesehen; um an einem Knotenpunkt 304' eine negative Spannung bereitzustellen. Die negative Spannung wird über einen Widerstand 351 (z.B. 100R) an einen ersten Anschluss eines Kondensators 350 (z.B. 10nF) geführt, dessen zweiter Anschluss auf Massepotential liegt. Der Kondensator 350 wird daher negativ aufgeladen.

Weiterhin ist erkennbar, dass die Dioden 305 und 307 doppelt ausgeführt sind, wobei zwei Dioden 305' und 307' dazu in Reihe geschaltet sind. Deren Funktionsweise wird weiter unten erläutert werden.

Zum Einschalten des MOSFETs 400 wird der Transformator 200 primärseitig mit einem Gegentaktsignal, bspw. mit der Frequenz von 250khz, angesteuert. Dies erfolgt über die beiden Transistoren, z.B. FETs, 114, 115, die bspw. über Logikgatter (nicht gezeigt) angesteuert werden. Die damit sekundärseitig erzeugte Rechteckspannung wird gleichgerichtet und steht am Gate 401 des MOSFETs 400 als Gleichspannung zu Verfügung. Das Übersetzungsverhältnis des Transformators 200 ist so gewählt, das sich am Gate 401 unter Berücksichtigung von Diodenflußspannungen und Durchlassverlusten der Ansteuertransistoren. 114, 115 eine Spannung von etwa +15 V ergibt.

Der Ladestrom der Gatekapazität des MOSFETs 400 und eines parallelen Kondensators 309 (z.B. 10nF), wird von einem Widerstand 306 (z.B. 10R) und dem RDSₒₙ der FETs 114, 115 begrenzt. Über die Höhe des Ladestromes kann die Einschaltgeschwindigkeit des MOSFETs eingestellt werden. Der parallel zur Gate-Source-Strecke des MOSFETs 400 vorgesehene Kondensator 309 hat die Aufgabe, die während der "Ein"-Phase über die Millerkapazität des MOSFETs eingekoppelten Störströme abzupuffern und somit die Gatespannung des MOSFETs "sauber" von Störspikes zu halten.

Ein zu dem Kondensator 309 parallel geschalteter Widerstand (z.B. 4K99) sorgt auch bei erreichen der max. Gatespannung für einen Strom durch die Ladedioden 305, 305' und damit zu einer definierten Flußspannung.

Bei der gezeigten Ausführung wird die Gatespannung zusätzlich über eine Diodenanordnung 311, die als Zenerdiode mit Verpolschutz ausgebildet ist, an der Basis 321 des pnp-Transistors 320 auf zulässige Werte. (z.B. kleiner 20 V) begrenzt. Diese Diodenanordnung ist optional und kann auch weggelassen werden.

Zum Ausschalten des MOSFETs 400 wird die Ansteuerung über den Transformator 200 beendet. Während der "Ein"-Phase ist der pnp-Transistor 320 geschlossen, da an seiner U_{BE} Strecke keine Spannung entsteht. Wird die Ansteuerung des Transformators 200 beendet, fällt an der Basis 321 des pnp-Transistors 320 anliegende positive Potential über den Widerstand 308 (2k) in Richtung des Wertes der negativen Hilfsspannung. Die an der Gate-Elektrode 401 des MOSFETs 400 anliegende positive Spannung ist über die Dioden 305, 305' abgekoppelt. Somit baut sich eine negative Spannung U_{BE} zwischen der Basiselektrode 321 des pnp-Transistors 320 und der Gate-Elektrode 401 des MOSFETs 400 auf. Erreicht diese negative Spannung einen vorbestimmten Wert, den Schwellwert des pnp-Transistors 320, so wird der pnp-Transistor 320 zwischen seiner Emitterelektrode 322 und seiner Kollektorelektrode 323 leitend. Die Gate-Elektrode 401 des MOSFETs 400 ist damit ebenfalls mit Massepotential verbunden, wodurch sie sich entlädt.

Die Ausschaltgeschwindigkeit des MOSFETs kann über die Zeitkonstante des Basiswiderstandes 308 und einer parallelen Kapazität 352 (z.B. 330pF) unter Berücksichtigung des Basisstromanteils eingestellt werden.

Über die zwei Dioden 301' und 302', den Widerstand 351 zur Strombegrenzung und die Kapazität 350 wird eine negative Hilfsspannung erzeugt. Diese ist notwendig, um den prinzipiellen Nachteil dieses Treiberstufenkonzepts, nämlich die unipolare Gateansteuerung, zu kompensieren. Wie mit Bezugnahme auf Figur 1 (Stand der Technik) erläutert, könnte das Gate 401 des MOSFETs 400 nur auf die Summe aus U_{BE} des pnp-Transistors 320 und dem Spannungsabfall an seinem Basiswiderstand 308 entladen werden, wenn der Basiswiderstand 3.08 des pnp-Transistors 320 nicht mit der negativen Hilfsspannung sondern dem Emitterpotential des MOSFETs 400 verbunden wäre. Dies hätte zur Folge, dass der bei der Umladung der Millerkapazität des MOSFETs entstehende Stromfluss die Gatekapazität auf mindestens. 2,5V aufladen würde. Um aber genug Spannungsabstand zur minimalen Threshold-Spannung des MOSFETs (typisch min. 5V) zu haben, ist es zwingend notwendig die Gatespannung unter allen Umständen unter 2,5 V zu halten. Durch den Bezug des Basiswiderstands 308 auf die negative Hilfsspannung kann das Gate 401 des MOSFETs 400 bis auf 0 V entladen werden, da sich das Basispotential des pnp-Transistors 320 im ausgeschalteten Zustand auf -2,1 V befindet. Trotz negativerer Hilfsspannung können an der Basis 321 des pnp-Transistors 320 aber nicht mehr als -2,1 V entstehen, da die Basis 321 über die drei Dioden 302, 307, 307' und die Wicklung 203 bzw. die drei Dioden 301, 307, 307' und die Wicklung 204 des ausgeschalteten Transformators 200 auf das Source-Potential (z.B. Masse) des MOSFETs 400 geklemmt wird.

Bei der Erzeugung des primärseitigen Gegentaktansteuerungssignals für den Transformator 200 sollte vorzugsweise darauf geachtet werden, dass bei synchronem Beginn des Takt- und Ansteuersignals die FETs 114, 115 jeweils abwechselnd angesteuert werden, um eine Sättigung des Transformators durch einseitige Aufmagnetisierung zu verhindern. Dies erweist sich als vorteilhaft, da der größte Teil der Ansteuerenergie bereits im ersten Takt übertragen wird.

Es versteht sich, dass die vorstehend erläuterten bevorzugten Ausführungsformen des erfindungsgemäßen Verfahrens nur beispielhaft zu verstehen sind. Daneben sind für einen Fachmann weitere Lösungen denkbar, ohne den Rahmen der vorliegenden Ansprüche zu verlassen.

## Patentansprüche

1. Schaltungsanordnung (100) zur galvanisch getrennten Ansteuerung eines als Feldeffekttransistor oder IGBT ausgebildeten Halbleiterschalters (400),
wobei die Schaltungsanordnung einen Steuerkreis (101), d.h. einen Schaltungsteil auf Ansteuerpotential, einen Treiberkreis (102), d.h. einen Schaltungsteil auf Schalterpotential, einen Transformator (200) zum galvanisch getrennten Übertragen eines Ansteuersignals aus dem Steuerkreis (101) als Schaltsignal in den Treiberkreis (102) und Mittel zum Gleichrichten (301, 302) des Schaltsignals aufweist,
wobei der Halbleiterschalter (400) mit einer Gate-Elektrode (401), einer Source-Elektrode (402) und einer Drain-Elektrode (403) in dem Treiberkreis (102) ausgebildet und durch eine vorbestimmte erste Spannung zwischen der Gate-Elektrode (401) und der Source-Elektrode (402) schaltbar ist, so dass ein vorbestimmter Strom zwischen der Drain-Elektrode (403) und der Source-Elektrode (402) fließt,
wobei ein Anschluss der Mittel zum Gleichrichten (301, 302) mit der Gate-Elektrode (401) verbunden ist und so das gleichgerichtete Schaltsignal an die Gate-Elektrode (401) anlegbar ist, um den Halbleiterschalter (400) zu schließen,
wobei der Treiberkreis (102) einen als bipolarer pnp-Transistor ausgebildeten Steuertransistor (320) mit einer Basiselektrode (321), einer Emitterelektrode (322), die mit der Gate-Elektrode (401) des Halbleiterschalters (400) verbunden ist, und einer Kollektorelektrode (323), die mit der Source-Elektrode (402) des Halbleiterschalters (400) verbunden ist, enthält, und der Steuertransistor (320) durch eine vorbestimmte negative Spannung zwischen der Basiselektrode (321) und der Emitterelektrode (322) schaltbar ist, so dass über die Emitterelektrode (322) und die Kollektorelektrode (323) die Gate-Elektrode (401) des Halbleiterschalters (400) mit der Source-Elektrode (402) des Halbleiterschalters (400) verbindbar ist, um den Halbleiterschalter zu öffnen,
wobei der Treiberkreis (102) wenigstens ein kapazitives Bauteil als Spannungserzeugungsmittel (350) zum Erzeugen einer negativen Spannung zwischen der Basiselektrode (321) und der Kollektorelektrode (323) des Steuertransistors (320) enthält, wobei das wenigstens eine kapazitive Bauteil (350) mit den Mitteln zum Gleichrichten (301, 302) verbunden ist,
wobei die Schaltungsanordnung so ausgebildet ist, dass der Halbleiterschalter (400) erst nach Abschalten des Ansteuersignals mittels der negativen Spannung zwischen der Basiselektrode (321) und der Kollektorelektrode (323) des Steuertransistors (320) geöffnet wird.

2. Schaltungsanordnung (100) nach Anspruch 1, **dadurch gekennzeichnet, dass** die Basiselektrode (321) des Steuertransistors (320) mit einem Pol der Spannungserzeugungsmittel (350) und über wenigstens eine, vorzugsweise zwei oder drei Dioden (301, 307, 307'; 302, 307, 307'), insbesondere über Teile (203, 204) des Transformators (200), mit der Source-Elektrode (402) des Halbleiterschalters (400) verbunden ist.

3. Schaltungsanordnung (100) nach einem der vorstehenden Ansprüche, **gekennzeichnet durch** eine Diodenanordnung (311), welche wenigstens eine Z-Diode mit Verpolschutz aufweist, zwischen der Basiselektrode (321) und der Kollektorelektrode (322) des Steuertransistors (320) zum Begrenzen der Spannung zwischen der Gate-Elektrode (401) und der Source-Elektrode (402) des Halbleiterschalters (400).

4. Schaltungsanordnung (100) nach einem der vorstehenden Ansprüche, **gekennzeichnet durch** ein kapazitives Bauteil (309), insbesondere einen Kondensator, zwischen der Gate-Elektrode (401) und der Source-Elektrode (402) des Halbleiterschalters (400) zum Abpuffern von über eine Miller-Kapazität des Halbleiterschalters (400) eingekoppelten Störströmen.

5. Schaltungsanordnung (100) nach einem der vorstehenden Ansprüche, **dadurch gekennzeichnet, dass** der Halbleiterschalter (400) als MOSFET ausgebildet ist.

6. Schaltungsanordnung (100) nach einem der vorstehenden Ansprüche, **dadurch gekennzeichnet, dass** die Basiselektrode (321) des Steuertransistors (320) mit dem negativen Pol der Spannungserzeugungsmittel (350) und über wenigstens zwei, vorzugsweise drei Dioden (301, 307, 307'; 302, 307, 307') mit der Source-Elektrode (402) des Halbleiterschalters (400) verbunden ist.

7. Verfahren zur galvanisch getrennten Ansteuerung eines Halbleiterschalters (400),
wobei eine Schaltungsanordnung (100) nach einem der vorstehenden Ansprüche verwendet wird,
wobei durch das Ansteuersignal im Steuerkreis das gleichgerichtete Schaltsignal an die Gate-Elektrode (401) angelegt wird, um den Halbleiterschalter (400) zu schließen, und das wenigstens eine kapazitive Bauteil (250) durch das gleichgerichtete Schaltsignal geladen wird,
wobei zum Öffnen des Halbleiterschalters (400) das Ansteuersignal abgeschaltet wird und nach dem Abschalten des Ansteuersignals durch das wenigstens eine geladene kapazitive Bauteil (250) die negative Spannung zwischen der Basiselektrode (321) und der Kollektorelektrode (323) des Steuertransistors (320) erzeugt wird.

## Claims

1. Circuit arrangement (100) for the electrically isolated driving of a semiconductor switch (400) embodied as a field effect transistor or an IGBT, wherein the circuit arrangement has a control circuit (101), i.e. a circuit section at driving potential, a driver circuit (102), i.e. a circuit section at switch potential, a transformer (200) for the electrically isolated transmission of a driving signal from the control circuit (101) as switching signal into the driver circuit (102) and means for rectifying (301, 302) the switching signals,
wherein the semiconductor switch (400) is embodied with a gate electrode (401), a source electrode (402) and a drain electrode (403) in the driver circuit (102) and can be switched by a predetermined first voltage between the gate electrode (401) and the source electrode (402), such that a predetermined current flows between the drain electrode (403) and the source electrode (402),
wherein a connection of the rectifying means (301, 302) is connected to the gate electrode (401) and the rectified switching signal can thus be applied to the gate electrode (401) in order to close the semiconductor switch (400),
wherein the driver circuit (102) contains a control transistor (320) embodied as a bipolar pnp transistor and having a base electrode (321), an emitter electrode (322), which is connected to the gate electrode (401) of the semiconductor switch (400), and a collector electrode (323), which is connected to the source electrode (402) of the semiconductor switch (400), and the control transistor (320) can be switched by a predetermined negative voltage between the base electrode (321) and the emitter electrode (322), such that, via the emitter electrode (322) and the collector electrode (323), the gate electrode (401) of the semiconductor switch (400) can be connected to the source electrode (402) of the semiconductor switch (400) in order to open the semiconductor switch, wherein the driver circuit (102) contains at least one capacitive component as voltage generating means (350) for generating a negative voltage between the base electrode (321) and the collector electrode (323) of the control transistor (320), wherein the at least one capacitive component (350) is connected to the rectifying means (301, 302),
wherein the circuit arrangement is designed such that the semiconductor switch (400) is opened only after the switching-off of the driving signal by means of the negative voltage between the base electrode (321) and the collector electrode (323) of the control transistor (320).

2. Circuit arrangement (100) according to Claim 1, **characterized in that** the base electrode (321) of the control transistor (320) is connected to a pole of the voltage generating means (350) and, via at least one, preferably two or three diodes (301, 307, 307'; 302, 307, 307'), in particular via parts (203, 204) of the transformer (200), to the source electrode (402) of the semiconductor switch (400).

3. Circuit arrangement (100) according to either of the preceding claims, **characterized by** a diode arrangement (311), which has at least one zener diode with polarity reversal protection, between the base electrode (321) and the collector electrode (322) of the control transistor (320) for limiting the voltage between the gate electrode (401) and the source electrode (402) of the semiconductor switch (400).

4. Circuit arrangement (100) according to any of the preceding claims, **characterized by** a capacitive component (309), in particular a capacitor, between the gate electrode (401) and the source electrode (402) of the semiconductor switch (400) for buffering interference currents coupled in via a Miller capacitance of the semiconductor switch (400).

5. Circuit arrangement (100) according to any of the preceding claims, **characterized in that** the semiconductor switch (400) is embodied as a MOSFET.

6. Circuit arrangement (100) according to any of the preceding claims, **characterized in that** the base electrode (321) of the control transistor (320) is connected to the negative pole of the voltage generating means (350) and, via at least two, preferably three diodes (301, 307, 307'; 302, 307, 307'), to the source electrode (402) of the semiconductor switch (400).

7. Method for the electrically isolated driving of a semiconductor switch (400),
wherein a circuit arrangement (100) according to any of the preceding claims is used,
wherein, by means of the driving signal in the control circuit, the rectified switching signal is applied to the gate electrode (401) in order to close the semiconductor switch (400), and the at least one capacitive component (250) is charged by the rectified switching signal,
wherein, for the purpose of opening the semiconductor switch (400), the driving signal is switched off and the negative voltage between the base electrode (321) and the collector electrode (323) of the control transistor (320) is generated after the switching-off of the driving signal by the at least one charged capacitive component (250).

## Revendications

1. Dispositif de circuit (100) pour attaquer de manière galvaniquement isolée un commutateur à semi-conducteur (400) réalisé sous la forme d'un transistor à effet de champ ou IGBT,
dans lequel le dispositif de circuit comprend un circuit de commande (101), à savoir une partie de circuit au potentiel d'attaque, un circuit d'attaque (102), à savoir une partie de circuit au potentiel de commutation, un transformateur (200) destiné à transmettre de manière galvaniquement isolée un signal de commande depuis le circuit de commande (101) en tant que signal de commutation dans le circuit d'attaque (102) et des moyens de redressement (301, 302) du signal de commutation,
dans lequel ledit commutateur à semi-conducteur (400) est réalisé de manière à comporter une électrode de grille (401), une électrode de source (402) et une électrode de drain (403) dans le circuit d'attaque (102) et peut être commuté par une première tension prédéterminée entre l'électrode de grille (401) et l'électrode de source (402), de telle sorte qu'un courant prédéterminé passe entre l'électrode de drain (403) et l'électrode de source (402),
dans lequel une liaison des moyens de redressement (301, 302) est connectée à l'électrode de grille (401) de telle sorte que le signal de commutation redressé puisse être appliqué à l'électrode de grille (401) pour fermer le commutateur à semi-conducteur (400),
dans lequel le circuit d'attaque (102) comprend un transistor de commande (320)réalisé sous la forme d'un transistor pnp bipolaire comportant une électrode de base (321), une électrode d'émetteur (322) qui est connectée à l'électrode de grille (401) du commutateur à semi-conducteur (400), et une électrode de collecteur (323) qui est connectée à l'électrode de source (402) du commutateur à semi-conducteur (400), et dans lequel le transistor de commande (320) peut être commuté par l'intermédiaire d'une tension négative prédéterminée entre l'électrode de base (321) et l'électrode d'émetteur (322), de telle sorte que l'électrode de grille (401) du commutateur à semi-conducteur (400) puisse être connectée à l'électrode de source (402) du commutateur à semi-conducteur (400) par l'intermédiaire de l'électrode d'émetteur (322) et de l'électrode de collecteur (323) pour ouvrir le commutateur à semi-conducteur,
dans lequel le circuit d'attaque (102) comprend au moins un composant capacitif en tant que moyens générateurs de tension (350) pour générer une tension négative entre l'électrode de base (321) et l'électrode de collecteur (323) du transistor de commande (320), ledit au moins un composant capacitif (350) étant connecté aux moyens de redressement (301, 302),
dans lequel le dispositif de circuit est conçu de telle sorte que le commutateur à semi-conducteur (400) ne soit ouvert qu'après l'interruption du signal d'attaque au moyen de la tension négative entre l'électrode de base (321) et l'électrode de collecteur (323) du transistor de commande (320).

2. Dispositif de circuit (100) selon la revendication 1, **caractérisé en ce que** l'électrode de base (321) du transistor de commande (320) est connectée à un pôle des moyens générateurs de tension (350) et est connectée par l'intermédiaire d'au moins une, et de préférence deux ou trois diodes (301, 307, 307' ; 302, 307, 307'), et notamment par l'intermédiaire de parties (203, 204) du transformateur (200), à l'électrode de source (402) du commutateur à semi-conducteur (400).

3. Dispositif de circuit (100) selon l'une quelconque des revendications précédentes, **caractérisé par** un dispositif à diodes (311) comportant au moins une diode Zener en polarité inversée entre l'électrode de base (321) et l'électrode de collecteur (322) du transistor de commande (320) pour limiter la tension entre l'électrode de grille (401) et l'électrode de source (402) du commutateur à semi-conducteur (400).

4. Dispositif de circuit (100) selon l'une quelconque des revendications précédentes, **caractérisé par** un composant capacitif (309), notamment un condensateur, entre l'électrode de grille (401) et l'électrode de source (402) du commutateur à semi-conducteur (400) pour mettre en tampon des courants parasites (400) injectés par l'intermédiaire d'une capacité Miller du commutateur à semi-conducteur.

5. Dispositif de circuit (100) selon l'une quelconque des revendications précédentes, **caractérisé en ce que** le commutateur à semi-conducteur (400) est réalisé sous la forme d'un MOSFET.

6. Dispositif de circuit (100) selon l'une quelconque des revendications précédentes, **caractérisé en ce que** l'électrode de base (321) du transistor de commande (320) est connectée au pôle négatif des moyens générateurs de tension (350) et est connectée par l'intermédiaire d'au moins deux, et de préférence trois diodes (301, 307, 307' ; 302, 307, 307') à l'électrode de source (402) du commutateur à semi-conducteur (400).

7. Procédé d'attaque galvaniquement isolée d'un commutateur à semi-conducteur (400),
dans lequel un dispositif de circuit (100) selon l'une quelconque des revendications précédentes est utilisé, dans lequel le signal de commutation est appliqué, dans le circuit de commande, par l'intermédiaire du signal d'attaque redressé à l'électrode (401) pour fermer le commutateur à semi-conducteur (400), et ledit au moins un composant capacitif (250) est chargé par le signal de commutation redressé,
dans lequel, pour ouvrir le commutateur à semi-conducteur (400), le signal d'attaque est interrompu et, après l'interruption du signal d'attaque, la tension négative entre l'électrode de base (321) et l'électrode de collecteur (323) du transistor de commande (320) est générée par ledit au moins un composant capacitif chargé (250).
